(19) Europäisches Patentamt
European Patent Office
Office européen des brevets

(11) EP 0 578 196 B1

(12) **EUROPEAN PATENT SPECIFICATION**

(45) Date of publication and mention
of the grant of the patent:
**07.05.1997   Bulletin 1997/19**

(51) Int Cl.6: **H01L 43/10**

(21) Application number: **93110775.9**

(22) Date of filing: **06.07.1993**

(54) **Magnetoresistive elements and method of fabricating the same**

Magnetoresistive Elemente und Verfahren zu ihrer Herstellung

Eléments magnétoresistives et procédé de sa fabrication

(84) Designated Contracting States:
**DE FR GB NL**

(30) Priority: **07.07.1992   JP 178740/92**

(43) Date of publication of application:
**12.01.1994   Bulletin 1994/02**

(73) Proprietor: **NEC CORPORATION**
**Tokyo (JP)**

(72) Inventor: **Motomura, Yoshihiro,**
**c/o NEC Corporation**
**Tokyo (JP)**

(74) Representative: **VOSSIUS & PARTNER**
**Postfach 86 07 67**
**81634 München (DE)**

(56) References cited:
**EP-A- 0 406 060       EP-A- 0 483 373**
**EP-A- 0 506 433       FR-A- 2 677 811**

• **PATENT ABSTRACTS OF JAPAN, vol. 16, no.**
**236 (E-1210) 29 May 1992 & JP-A-40 48 708**

**Description**

This invention relates to a magnetoresistive element for reading magnetic field intensity as signals in a magnetically recorded medium and a method of fabricating the same, and in more particular to a magnetoresistive element which is fabricated with a magnetoresistive film having high rate of change in resistance in small external magnetic field and a method of fabricating the same.

Since electromagnetic transducers, in which ferromagnetic magnetoresistance effect is utilized, are sensitive to low magnetic field intensity and are of a magnetic flux response type, it is possible to measure change in the magnetic field intensity with time with a high accuracy even if values of time differential of magnetic field are small. In addition, it is possible to fabricate the magnetoelectric transducers shrunk in size by using thin film technology, and thus they are widely utilized for magnetic field sensors, magnetic heads and etc. In the past, such magnetoresistive elements have been fabricated with ferromagnetic thin films made of a NiFe alloy, NiCo alloy or the like. In the magnetoresistive elements, so-called anisotropic magnetoresistance effect in the thin films have been utilized to achieve the intended object. In these magnetoresistive elements, an easy axis in the ferromagnetic thin film lies perpendicular to the direction of magnetic field to be sensed. In the conventional magnetic thin film wherein the anisotropic magnetoresistance effect in the film was utilized, rate of change in magnetic resistance or reluctance of the film was 2 to 5%. The magnetic thin film having higher rate of change in magnetic resistance has been required.

Recently, it has been found that, in a magnetic multilayer film with different magnetic thin layers in which magnetic layers of thin NiFe and Co films are alternately stacked with the interposition of a layer of a nonmagnetic thin film therebetween, the magnetic multilayer film have higher rate of change in reluctance, i.e. the rate of approximately 10% at room temperature (H. Yamamoto et al., Journal of The Physical Society of Japan, Vol. 59, No. 9, September, 1990, pp.3061-3064 "Large Magnetoresistance of Field-Induced Giant Ferrimagnetic Multilayers"). In the magnetoresistive element which was made of materials having the great magnetoresistance effect, however, when the conventional magnetic layers do not have uniaxial anisotropy, it is necessary to once apply to the magnetoresistive element the external magnetic field which is higher than coercive force Hc of these magnetic layers, to thereby arrange the direction of magnetization in the respective magnetic layers to be parallel to each other. Also, if the external magnetic field higher than the Hc is applied to the magnetoresistive element during operation thereof, the relationship of the direction of magnetization in the respective magnetic layers changes and thus the manner of change in resistance also changes. Furthermore, resistance in the magnetic multilayer film changes depending on relative magnetization direction of the respective magnetic layers. Thus, if the magnetization direction of one of the magnetic layers is perpendicular to the externally applied magnetic field, the magnetization direction in one magnetic thin layer and that in the other magnetic thin layer are only at a right angle to each other and thus sufficiently large change in resistance was not obtained.

EP-A-0 483 373 discloses a magnoresistive multilayer element as described in the preamble of claim 1.

Accordingly, an object of this invention is to provide a magnetoresistive element which has extremely great change in magnetic resistance and can produce high output, and a method of fabricating the magnetoresistive element. This object is solved with the features of the claims.

The foregoing and other objects and features of the present invention will be apparent from the following description.

FIG. 1 is a partially structural view showing an embodiment of a magnetoresistive element according to this invention; and
FIGS. 2A and 2B are diagrams for explaining uniaxial anisotropy, a direction of signal magnetic field and a direction of magnetization in a magnetoresistive element according to this invention.

In a magnetoresistive element according to this invention, it is essential that coercive force of ferromagnetic thin layers adjacent to each other with the interposition of a nonmagnetic thin layer is different from each other and further that the respective ferromagnetic thin layers have uniaxial anisotropy in parallel with the direction of external signal magnetic field. The reason resides in that this invention is based on the principle that resistance of the magnetoresistive element becomes maximum when the magnetization direction in adjacent ferromagnetic thin layers is opposite to each other. Namely, in this invention, when the external magnetic field ($H_1$) lies between coercive force $Hc_2$ of one of the adjacent ferromagnetic thin layers and coercive force $Hc_3$ of the other layer ($Hc_2 < H_1 < Hc_3$), the magnetization direction in the adjacent ferromagnetic thin layers is opposite to each other and thus the resistance increases.

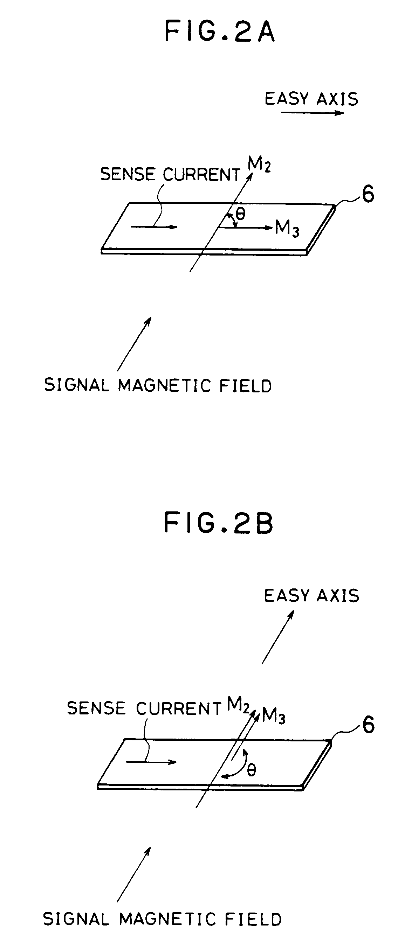

Moreover, in the case where the magnetization direction ($M_3$) in the ferromagnetic thin layer having the coercive force $Hc_3$ is perpendicular to the direction of the signal magnetic field at zero magnetic field, if signal magnetic field having intensity less than $Hc_3$ is only applied to a multilayer film 6 (FIG. 2A) comprising the ferromagnetic thin layers and the nonmagnetic thin layer as mentioned below, the direction of magnetization ($M_2$) of the ferromagnetic thin layer having the coercive force $Hc_2$ rotates only in parallel with the signal magnetic field. Therefore, as shown in FIG. 2A, the direction of $M_2$ and that of $M_3$ are only at a right angle ($\theta = 90$ degrees) to each other. Thus, the opposite direction of magnetization in the adjacent ferromagnetic layers cannot be obtained, and sufficient change in resistance cannot be also obtained.

If the ferromagnetic thin layers have the uniaxial anisotropy in parallel with the direction of signal magnetic field, the direction of magnetization $M_3$ in the ferromagnetic thin layer having coercive force $Hc_3$ and that of $M_2$ in the ferromagnetic thin layer having coercive force $Hc_2$ are always in parallel with the direction of signal magnetic field at the zero magnetic field, as shown in FIG. 2B. When a signal magnetic field (Hex) having intensity less than $Hc_3$ is applied to the multilayer film 6, the magnetization $M_3$ rotates in accordance with the intensity of Hex and the direction of $M_3$ is in parallel with that of $M_2$. Thus, high rate of change in resistance can be obtained.

Furthermore, even if the external magnetic field exceeding $Hc_3$ is temporally applied to the multilayer film from the different direction from that of the signal magnetic field to thereby direct $M_3$ to different direction, the direction of $M_3$ returns to that of the external signal magnetic field (i.e. the direction of easy axis) when the external magnetic field is removed, and thus the relationship between $M_2$ and $M_3$ can return to a proper state.

Next, an embodiment of this invention will be hereinafter described in more detail with reference to accompanying drawings and the effects practically achieved by this invention will also be discussed in detail in comparison with comparative Example.

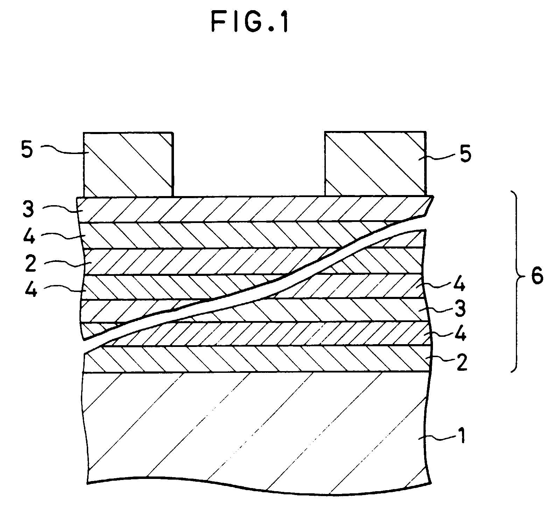

Referring now to FIG. 1, which is a partially structural view showing an embodiment of the magnetoresistive element according to this invention, the magnetoresistive element comprises a substrate 1; a multilayer film 6 having a plurality of first ferromagnetic thin layers 2, a plurality of second ferromagnetic thin layers 3 having coercive force smaller than that of the first ferromagnetic thin layer 2 and nonmagnetic thin layers 4; and electrodes 5 mounted on top of the multilayer film 6. The multilayer film 6 is formed so that the first ferromagnetic thin layer 2 and the second ferromagnetic thin layer 3 are alternately deposited and stacked on the substrate 1 with the interposition of the nonmagnetic thin layer 4 therebetween. As shown in FIG. 1, the first ferromagnetic thin layer 2, the nonmagnetic thin layer 4, the second ferromagnetic thin layer 3 and the nonmagnetic thin layer 4 are repeatedly deposited and stacked on the substrate 1 in order, provided that the layer to be finally stacked is the ferromagnetic layer 3. In other words, the multilayer film 6 is composed so that the ferromagnetic thin layer 2 is initially stacked on the substrate 1 and the ferromagnetic thin layer 3 is finally stacked on the nonmagnetic thin layer 4. However, the effect of this invention does not depend on the order of the ferromagnetic thin layers and 2 and 3 and the nonmagnetic layer 4 to be stacked. For instance, the multilayer film 6 may be composed so that the second layer 3 or the nonmagnetic layer 4 is initially stacked on the substrate 1 and the first layer 2 or the nonmagnetic layer 4 is finally stacked. Furthermore, in order to improve crystal structure and magnetic properties of the ferromagnetic layer, an underlying layer made of a material, such as Au, Cu, Ag, Pt, Cr, Fe or the like, is formed between the substrate 1 and the multilayer film 6.

A kind of a magnetic material for the ferromagnetic thin layer is not particularly limited. For instance, there can be preferably used Fe, Co, Mn, Cr, Dy, Er, Nd, Tb, Tm, Ge, Gd or the like. In addition, there can be used alloys or compounds containing these elements, for instance, preferably Fe-Si, Fe-Ni, Fe-Co, Fe-Gd, Ni-Fe-Co, Ni-Fe-Mo, Fe-Al-Si (Sendust), Fe-Y, Fe-Mn, Cr-Sb, Co series amorphous, Co-Pt, Fe-Al, Fe-C, Mn-Sb, Ni-Mn, Co-O, Ni-O, Fe-O, ferrite or the like.

In this invention, the ferromagnetic thin layers are formed of at least two magnetic materials selected from the above-mentioned magnetic materials, the selected materials having different coercive force from one another. In the resulting multilayer film, easy axis in the ferromagnetic thin layer is in parallel with the direction of applied signal magnetic field. The film-forming is performed by the conventional process such as evaporation process, sputtering process, molecular beam epitaxy process (MBE) or the like. Furthermore, as for a material for the substrate 1, there can be used, for instance, glass, Si, MgO, GaAs, ferrite, CaTiO or the like.

The upper limit of a thickness of the respective ferromagnetic thin layers is $2 \cdot 10^{-2}$ µm (200 angstroms) preferably $10^{-2}$ µm (100 angstroms), whereas the lower limit thereof is not particularly limited but is preferably $4 \cdot 10^{-4}$ µm (4 angstroms). If the film thickness is controlled to $4 \cdot 10^{-4}$ µm (4 angstroms) or more, it is easy to keep the film thickness to be uniform and thus it is possible to obtain good film quality, and further dimension of saturated magnetization is not too small and is proper for the intended object. If the film thickness is less than $4 \cdot 10^{-4}$ µm (4 angstroms), Curie point is less than room temperature and thus the resulting multilayer film is not practical use. Even if the film thickness exceeds $2 \cdot 10^{-2}$ µm (200 angstroms), the effect of this invention can be retained but does not increase with an increase in the film thickness. Such increased film thickness is useless in fabrication of the film and is not economical.

The coercive force in each ferromagnetic layer may be conveniently selected from, for instance, a range of $(1/4\pi)$ A/m (0.001 Oe) to $10^7 \cdot (1/4\pi)$A/m (10 kOe), corresponding to external magnetic field intensity and required rate of change in resistance in the magnetoresistive elements to be applied. In addition, ratio of the coercive force in adjacent ferromagnetic thin layers falls within the range of 1.2:1 to 100:1, preferably 5:1 to 50:1, more preferably 8:1 to 20:1.

Incidentally, it is impossible to directly measure magnetic properties of the ferromagnetic thin layers in the magnetoresistive element and thus the properties were ordinarily measured as follows.

The ferromagnetic thin layer to be measured and the nonmagnetic thin layer were alternately vaporized on a substrate till the total thickness of the ferromagnetic thin layers is $5 \cdot 10^{-3}$ to $4 \cdot 10^{-2}$ µm (50 to 400 angstroms), to give a measuring sample. In this case, the thickness of the ferromagnetic thin layer and the thickness and composition of the nonmagnetic thin layer are selected so as to be the same as in the magnetoresistive element. The magnetic properties were measured on the resulting sample.

Moreover, the nonmagnetic thin layer has a role being played in weakening of magnetointeraction between the adjacent ferromagnetic thin layers each having different coercive force. A material for forming the nonmagnetic thin layer is not particularly limited and may be conveniently selected from various nonmagnetic materials of metals, semimetals and nonmetals.

The metal nonmagnetic material includes, for instance, preferably Au, Ag, Cu, Pt, Al, Mg, Mo, Zn, Nb, Ta, V, Hf, Sb, Zr, Ga, Ti, Sn, Pb or the like and alloys thereof. The semimetal nonmagnetic material includes, for instance, preferably $SiO_2$, SiO, SiN, $Al_2O_3$, ZnO, MgO, TiN or the like and these compounds to which another element is added.

It is preferred that the nonmagnetic thin layer is not more than $2 \cdot 10^{-2}$ μm (200 angstroms) thick. If the film thickness exceeds $2 \cdot 10^{-2}$ μm (200 angstroms), generally resistance is determined depending on the nonmagnetic thin layer and scattering effect depending on spin is relatively reduced. As a result, the rate of change in magnetic resistance is reduced. On the other hand, if the film thickness is less than $4 \cdot 10^{-4}$ μm (4 angstroms), the magnetointeraction between the ferromagnetic thin layers is too large and magnetically direct contact state (pinhole) inevitably occurs. Thus, it is difficult to create a state that the adjacent ferromagnetic thin layers are different from each other in the direction of magnetization.

The thickness of the ferromagnetic and nonmagnetic thin layers can be measured by means of a transmission electron microscope, scanning electron microscope, Auger electron spectroscopy or the like. In addition, the crystal structure of the thin layer can be confirmed by an X-ray diffraction, high energy electron diffraction or the like.

In the magnetoresistive element of this invention, the number (N) of the ferromagnetic thin layers in the multilayer film or superlattice films to be repeatedly stacked is not particularly limited and is conveniently determined according to the prescribed rate of change in magnetic resistance or the like. In order to obtain the sufficient rate of change in magnetic resistance, it is preferred that the number N is 4 or more. The rate of change in magnetic resistance increases as the number N increases, but the productivity is lowered with an increase in N. If N is overlarge, resistance in the whole element becomes too low and thus the resulting element is inconvenient in practical application. For this reason, it is generally preferred that N is 100 or less.

In the magnetoresistive element as explained above, only two kinds of the ferromagnetic thin layers each having different coercive force are used as the ferromagnetic thin layer. However, the ferromagnetic thin layers of three kinds or more each having different coercive force may be used, whereby it is possible to dispose the external magnetic fields, in which the direction of magnetization changes, at two places or more and thus to enlarge a range of intensity of operating magnetic field.

Incidentally, an oxidation inhibitor film, which is formed of a material such as silicon nitride, silicon oxide or the like, may be located on the surface of the uppermost ferromagnetic thin layer and metallic conductive layer for drawing out electrodes may be disposed thereon.

The ferromagnetic materials of two kinds and the nonmagnetic metal material as mentioned above are evaporated in a vacuum evaporation device equipped with three sources for evaporation or a sputtering device with three targets. The three kinds of the materials can be alternately stacked on the substrate 1 by alternately opening and closing shutters in the three evaporation sources or by allowing the substrate 1 to pass alternately over the three evaporation sources. When the film is formed as mentioned above or the film is annealed after film-forming, induction magnetic anisotropy is induced so that the easy axis in the ferromagnetic thin layer is in parallel with the direction of the magnetic field to be sensed, by means of an application of DC magnetic field thereto and etc.

In the present embodiment, a Cr underlying layer about $5 \cdot 10^{-3}$ μm (50 angstroms) thick is formed on a glass substrate by an electron beam vacuum evaporation method, and a Co layer about $10^{-3}$ μm (10 angstroms) thick and a NiFe layer about $10^{-3}$ μm (10 angstroms) thick were alternately and successively stacked thereon with the interposition of a Cu layer about $4 \cdot 10^{-3}$ μm (40 angstroms) thick over five times. Thickness of each layer was controlled by setting the substrate temperature to be, for instance, about 50°C and the film-forming speed to be about 0.1 nm/sec and changing open-close cycle of the shutters in the respective evaporation sources. Degree of vacuum during evaporation was, for instance, about $6.65 \cdot 10^{-7}$ Pa (5 x $10^{-9}$ Torr). At this time, static magnetic field of, for instance, about $(5/4\pi) \cdot 10^5$ A/m (500 Oe) was applied to a direction which is in parallel with the direction of the field to be sensed in fabricating the element to thus induce the easy axis in the same direction.

Then, some magnetic multilayer films were fabricated in the same manner as in the above embodiment to give samples of Comparative Examples 1 and 2. As for Comparative Example 1, the easy axis was induced to be perpendicular to the direction of the field to be sensed whereas in Comparative Example 2, the magnetic field was not applied thereto during film-forming to give an isotropic film.

Then, in order to measure the magnetoresistance effect in the above-mentioned multilayer films, an Au film about 0.2 μm thick was deposited on each of the multilayer films by the evaporation method and then was patterned to give a thin line-like pattern having a width of 5 μm according to the photolithographic technology and ion etching technology. Thereafter, only the Au layer corresponding to a length of 5 μm of the portion to be sensed was removed by the chemical etching method to use the remaining Au layer as an electrode. Constant electric current of, for instance, 2 mA was applied across the resulting assemblies to measure resistance-magnetic field characteristics by a two-terminal method. The results of measurement are evaluated in the following Table 1.

Table 1

| Sample | Output (Relative Value) |
|---|---|
| Embodiment of This Invention | 1.0 |
| Comparative Example 1 | 0.5 |
| Comparative Example 2 | 0.6 |

As can be seen from the data shown in Table 1, the magnetoresistive element of this embodiment has large change in resistance as compared with the case where the easy axis was set in the same direction as that in the conventional magnetoresistive element or where the element was composed of the isotropic film, and as a result it is possible to obtain the larger output.

As discussed above, the magnetoresistive element according to this invention comprises the substrate and the magnetic multilayer film which is composed so that the plurality of kinds of ferromagnetic thin layers each having different coercive force are alternately and repeatedly stacked on the substrate with the interposition of each of the nonmagnetic thin layers therebetween, and further the easy axis in the ferromagnetic thin layers is set so as to be in parallel with the direction of magnetic field to be sensed, whereby it is possible to attain extremely large change in magnetic resistance and thus high output.

While this invention has been described in connection with certain preferred embodiments, it is to be understood that the subject matter encompassed by way of this invention is limited only by the scope of the following claims.

## Claims

1. A magnetoresistive element including a glass substrate (1); and a multilayer film (6) having a plurality of ferromagnetic thin layers (2, 3) and at least one nonmagnetic layer (4), said plurality of ferromagnetic thin layers (2, 3) being stacked on said substrate (1) with a nonmagnetic layer (4) being interposed between each of adjacent ferromagnetic layers and the coercive force in the adjacent ferromagnetic thin layers (2, 3) being different from each other, in which the easy axis of magnetization in said plurality of ferromagnetic thin layers (2, 3) is set to be in parallel with a direction of magnetic field to be sensed, characterized in that an underlying layer is further formed between said glass substrate (1) and the multilayer film (6), said underlying layer being made of a material selected from the group consisting of Au, Cu, Ag, Pt, Cr and Fe.

2. The magnetoresistive element as defined in Claim 1, wherein said ferromagnetic thin layers (2, 3) are composed of at least two kinds of ferromagnetic thin layers alternately stacked with the interposition of said nonmagnetic layer, each kind having different coercive force.

3. The magnetoresistive element as defined in claim 1 or 2, wherein the number of said ferromagnetic thin layers (2, 3) is at least 4.

4. The magnetoresistive element as defined in claim 1, 2, or 3, wherein the number of said ferromagnetic thin layers (2, 3) is 100 or less.

5. The magnetoresistive element as defined in any one of claims 1 to 4, wherein each of said ferromagnetic thin layers (2, 3) is made of a magnetic material selected from the group consisting of Fe, Co, Mn, Cr, Dy, Er, Nd, Tb, Tm, Ge and Gd, and alloys or compounds thereof.

6. The magnetoresistive element as defined in Claim 5, wherein said compound or alloy is a member selected from the group consisting of Fe-Si, Fe-Ni, Fe-Co, Fe-Gd, Ni-Fe-Co, Ni-Fe-Mo, Fe-Al-Si, Fe-Y, Fe-Mn, Cr-Sb, Co series amorphous, Co-Pt, Fe-Al, Fe-C, Mn-Sb, Ni-Mn, Co-O, Ni-O, Fe-O, and ferrite.

7. The magnetoresistive element as defined in any one of claims 1 to 6, wherein each of said ferromagnetic thin layers (2, 3) has a thickness of $4 \cdot 10^{-4}$ µm to $2 \cdot 10^{-2}$ µm (4 to 200 angstroms).

8. The magnetoresistive element as defined in any one of claims 1 to 7, wherein each of said ferromagnetic thin layers (2, 3) has a thickness of $4 \cdot 10^{-4}$ µm to $10^{-2}$ µm (4 to 100 angstroms).

9. The magnetoresistive element as defined in any one of claims 1 to 8, wherein said coercive force in each of said ferromagnetic thin layers (2, 3) falls within a range of $\frac{1}{4\pi}$ A/m to $\frac{1}{4\pi} \cdot 10^7$ A/m (0.001 Oe to 10 kOe).

10. The magnetoresistive element as defined in any one of claims 1 to 9, wherein a ratio of said coercive force in the adjacent ferromagnetic thin layers (2, 3) falls within the range of 1.2:1 to 100:1.

11. The magnetoresistive element as defined in any one of claims 1 to 10, wherein a ratio of said coercive force in the adjacent ferromagnetic thin layers (2, 3) falls within the range of 5:1 to 50:1.

12. The magnetoresistive element as defined in any one of claims 1 to 11, wherein a ratio of said coercive force in the adjacent ferromagnetic thin layers (2, 3) falls within the range of 8:1 to 20:1.

13. The magnetoresistive element as defined in any one of claims 1 to 12, wherein said nonmagnetic layer (4) is made of a nonmagnetic material selected from the group consisting of Au, Ag, Cu, Pt, Al, Mg, Mo, Zn, Nb, Ta, V, Hf, Sb, Zr, Ga, Ti, Sn and Pb, and compounds thereof; and $SiO_2$, SiO, SiN, $Al_2O_3$, ZnO, MgO and TiN, and these compounds to which another element is added.

14. The magnetoresistive element as defined in any one of claims 1 to 13, wherein said nonmagnetic layer (4) has a thickness of $4 \cdot 10^{-4}$ µm to $2 \cdot 10^{-2}$ µm (4 to 200 angstroms).

15. The magnetoresistive element as defined in anyone of Claims 1 to 14, wherein said underlying layer is a Cr layer about $5 \cdot 10^{-3}$ µm (50 angstroms) thick and said two kinds of ferromagnetic thin layers comprises Co layer about $10^{-3}$ µm (10 angstroms) thick and NiFe layer about $10^{-3}$ µm (10 angstroms) thick, said Co and NiFe layers being alternately and successively stacked on said Cr layer with the interposition of Cu layer about $4 \cdot 10^{-3}$ µm (40 angstroms) thick over five times.

16. A method of fabricating a magnetoresistive element in which an underlying layer is formed on a glass substrate (1) and a plurality of ferromagnetic thin layers (2, 3) each having different coercive forces are stacked on the underlying layer with a nonmagnetic layer (4) being interposed between each of adjacent ferromagnetic layers (2, 3); comprising film-forming each of said ferromagnetic thin layers in a magnetic field so that the easy axis of magnetization in said ferromagnetic thin layers (2, 3) is in parallel with a direction of a signal magnetic field to be applied, wherein the underlying layer is made of a material selected from the group consisting of Au, Cu, Ag, Pt, Cr and Fe.

**Patentansprüche**

1. Magnetowiderstandselement mit einem Glassubstrat (1); und einer mehrlagigen Schicht (6) mit mehreren dünnen ferromagnetischen Lagen (2, 3) und mindestens einer nichtmagnetischen Lage (4), wobei die mehreren dünnen ferromagnetischen Lagen (2, 3) auf dem Substrat (1) übereinandergeschichtet sind, wobei eine nichtmagnetische Lage (4) zwischen jeweils benachbarten ferromagnetischen Lagen angeordnet ist und die Koerzitivkraft in den benachbarten dünnen ferromagnetischen Lagen (2, 3) jeweils unterschiedlich ist, wobei die magnetische Vorzugsachse in den mehreren dünnen ferromagnetischen Lagen (2, 3) so eingestellt ist, daß sie zu einer Richtung des zu erfassenden Magnetfeldes parallel ist, dadurch gekennzeichnet, daß eine darunterliegende Lage ferner zwischen dem Glassubstrat (1) und der mehrlagigen Schicht (6) ausgebildet ist, wobei die darunterliegende Lage aus einem Material besteht, das aus der Gruppe gewählt ist, die aus Au, Cu, Ag, Pt, Cr und Fe besteht.

2. Magnetowiderstandselement nach Anspruch 1, wobei die dünnen ferromagnetischen Lagen (2, 3) aus mindestens zwei Arten von dünnen ferromagnetischen Lagen bestehen, die abwechselnd übereinandergeschichtet sind, wobei die nichtmagnetische Lage dazwischen angeordnet ist, wobei jede Art eine andere Koerzitivkraft aufweist.

3. Magnetowiderstandselement nach Anspruch 1 oder 2, wobei die Anzahl der dünnen ferromagnetischen Lagen (2, 3) mindestens 4 beträgt.

4. Magnetowiderstandselement nach Anspruch 1, 2 oder 3, wobei die Anzahl der dünnen ferromagnetischen Lagen (2, 3) 100 oder weniger beträgt.

**5.** Magnetowiderstandselement nach einem der Ansprüche 1 bis 4, wobei jede der dünnen ferromagnetischen Lagen (2, 3) aus einem magnetischen Material besteht, das aus der Gruppe gewählt ist, die aus Fe, Co, Mn, Cr, Dy, Er, Nd, Tb, Tm, Ge und Gd und Legierungen oder Verbindungen daraus besteht.

**6.** Magnetowiderstandselement nach Anspruch 5, wobei die Verbindung oder Legierung ein Element ist, das aus der Gruppe gewählt ist, die aus Fe-Si, Fe-Ni, Fe-Co, Fe-Gd, Ni-Fe-Co, Ni-Fe-Mo, Fe-Al-Si, Fe-Y, Fe-Mn, Cr-Sb, serienamorphem Co, Co-Pt, Fe-Al, Fe-C, Mn-Sb, Ni-Mn, Co-O, Ni-O, Fe-O und Ferrit besteht.

**7.** Magnetowiderstandselement nach einem der Ansprüche 1 bis 6, wobei jede der dünnen ferromagnetischen Lagen (2, 3) eine Dicke von $4 \cdot 10^{-4}$ µm bis $2 \cdot 10^{-2}$ µm (4 bis 200 Angström) hat.

**8.** Magnetowiderstandselement nach einem der Ansprüche 1 bis 7, wobei jede der dünnen ferromagnetischen Lagen (2, 3) eine Dicke von $4 \cdot 10^{-4}$ µm bis $10^{-2}$ µm (4 bis 100 Angström) hat.

**9.** Magnetowiderstandselement nach einem der Ansprüche 1 bis 8, wobei die Koerzitivkraft in jeder der dünnen ferromagnetischen Lagen (2, 3) in einem Bereich von $1/4\,\pi$ A/m bis $1/4\,\pi \cdot 10^7$ A/m (0,001 Oe bis 10 kOe) liegt.

**10.** Magnetowiderstandselement nach einem der Ansprüche 1 bis 9, wobei das Verhältnis der Koerzitivkraft in den benachbarten dünnen ferromagnetischen Lagen (2, 3) im Bereich von 1,2:1 bis 100:1 liegt.

**11.** Magnetowiderstandselement nach einem der Ansprüche 1 bis 10, wobei ein Verhältnis der Koerzitivkraft in den benachbarten dünnen ferromagnetischen Lagen (2, 3) im Bereich von 5:1 bis 50:1 liegt.

**12.** Magnetowiderstandselement nach einem der Ansprüche 1 bis 11, wobei ein Verhältnis der Koerzitivkraft in den benachbarten dünnen ferromagnetischen Lagen (2, 3) im Bereich von 8:1 bis 20:1 liegt.

**13.** Magnetowiderstandselement nach einem der Ansprüche 1 bis 12, wobei die nichtmagnetische Lage (4) aus einem nichtmagnetischen Material besteht, das aus der Gruppe gewählt ist, die aus Au, Ag, Cu, Pt, Al, Mg, Mo, Zn, Nb, Ta, V, Hf, Sb, Zr, Ga, Ti, Sn und Pb und Verbindungen daraus; und $SiO2$, $SiO$, $SiN$, $Al_2O_3$, $ZnO$, $MgO$ und $TiN$ und diesen Verbindungen, denen ein weiteres Element hinzugefügt ist, besteht.

**14.** Magnetowiderstandselement nach einem der Ansprüche 1 bis 13, wobei die nichtmagnetische Lage (4) eine Dicke von $4 \cdot 10^{-4}$ µm bis $2 \cdot 10^{-2}$ µm (4 bis 200 Angström) hat.

**15.** Magnetowiderstandselement nach einem der Ansprüche 1 bis 14, wobei die darunterliegende Lage eine Cr-Lage von etwa $5 \cdot 10^{-3}$ µm (50 Angström) Dicke ist und die beiden Arten von dünnen ferromagnetischen Lagen eine Co-Lage von etwa $10^{-3}$ µm (10 Angström) Dicke und eine NiFe-Lage von etwa $10^{-3}$ µm (10 Angström) Dicke aufweisen, wobei die Co- und NiFe-Lagen über fünfmal auf der Cr-Lage abwechselnd und aufeinanderfolgend übereinandergeschichtet sind, wobei eine Cu-Lage von etwa $4 \cdot 10^{-3}$ µm (40 Angström) Dicke dazwischen angeordnet ist.

**16.** Verfahren zur Herstellung eines Magnetowiderstandselements, bei dem eine darunterliegende Lage auf einem Glassubstrat (1) ausgebildet ist und mehrere dünne ferromagnetischen Lagen (2, 3) mit jeweils anderen Koerzitivkräften auf der darunterliegenden Lage übereinandergeschichtet sind, wobei eine nichtmagnetische Lage (4) zwischen den jeweils benachbarten ferromagnetischen Lagen (2, 3) angeordnet ist; mit dem Schritt: Schichtausbildung jeder der dünnen ferromagnetischen Lagen in einem Magnetfeld, so daß die magnetische Vorzugsachse in den dünnen ferromagnetischen Lagen (2, 3) parallel zu einer Richtung eines anzulegenden Signalmagnetfeldes ist, wobei die darunterliegende Lage aus einem Material besteht, das aus der Gruppe gewählt ist, die aus Au, Cu, Ag, Pt, Cr und Fe besteht.

**Revendications**

**1.** Élément magnétorésistif comportant un substrat de verre (1), et un film multicouche (6) ayant une pluralité de couches minces ferromagnétiques (2,3) et au moins une couche non-magnétique (4), ladite pluralité de couches minces ferromagnétiques (2,3) étant empilée sur ledit substrat (1), une couche non-magnétique (4) étant interposée entre chacune des couches ferromagnétiques adjacentes et les forces coercitives dans les couches minces ferromagnétiques adjacentes (2,3) étant différentes les unes des autres, dans lequel l'axe de facile aimantation dans ladite pluralité de couches minces ferromagnétiques (2,3) est fixé de façon à être parallèle à une direction d'un champ magnétique à détecter, caractérisé en ce qu'une couche sous-jacente est en outre formée entre ledit substrat de verre (1) et le film multicouche (6), ladite couche sous-jacente étant faite d'un matériau sélectionné dans le groupe constitué de Au, Cu, Ag, Pt, Cr et Fe.

2. Élément magnétorésistif selon la revendication 1, dans lequel lesdites couches minces ferromagnétiques (2,3) sont composées d'au moins deux types de couches minces ferromagnétiques empilées en alternance avec interposition de ladite couche non magnétique, chaque type ayant une force coercitive différente.

3. Élément magnétorésistif selon la revendication 1 ou 2, dans lequel le nombre desdites couches minces ferromagnétiques (2,3) est au moins de quatre.

4. Élément magnétorésistif selon la revendication 1, 2 ou 3, dans lequel le nombre desdites couches minces ferromagnétiques (2,3) est de 100 ou moins.

5. Élément magnétorésistif selon l'une quelconque des revendications 1 à 4, dans lequel chacune desdites couches minces ferromagnétiques (2,3) est faite d'un matériau magnétique sélectionné dans le groupe constitué de Fe, Co, Mn, Cr, Dy, Er, Nd, Tb, Tm, Ge et Gd, et des alliages ou des composés de ceux-ci.

6. Élément magnétorésistif selon la revendication 5, dans lequel ledit composé ou alliage est un élément sélectionné dans le groupe constitué de Fe-Si, Fe-Ni, Fe-Co, Fe-Gd, Ni-Fe-Co, Ni-Fe-Mo, Fe-Al-Si, Fe-Y, Fe-Mn, Cr-Sb, d'un composé amorphe de la série du Co, Co-Pt, Fe-Al, Fe-C, Mn-Sb, Ni-Mn, Co-O, Ni-O, Fe-O, et de ferrite.

7. Élément magnétorésistif selon l'une quelconque des revendications 1 à 6, dans lequel chacune desdites couches minces ferromagnétiques (2,3) a une épaisseur de $4 \cdot 10^{-4}$ µm à $2 \cdot 10^{-2}$ µm (4 à 200 angströms).

8. Élément magnétorésistif selon l'une quelconque des revendications 1 à 7, dans lequel chacune desdites couches minces ferromagnétiques (2,3) a une épaisseur de $4 \cdot 10^{-4}$ µm à $10^{-2}$ µm (4 à 100 angströms).

9. Élément magnétorésistif selon l'une quelconque des revendications 1 à 8, dans lequel ladite force coercitive dans chacune desdites couches minces ferromagnétiques (2,3) se situe dans une gamme de $1/4\pi$ A/m à $1/4\pi \cdot 10^{7}$ A/m (0,001 Oe à 10 kOe).

10. Élément magnétorésistif selon l'une quelconque des revendications 1 à 9, dans lequel le rapport desdites forces coercitives dans les couches minces ferromagnétiques adjacentes (2,3) se situe dans la gamme de 1,2:1 à 100:1.

11. Élément magnétorésistif selon l'une quelconque des revendications 1 à 10, dans lequel le rapport desdites forces coercitives dans les couches minces ferromagnétiques adjacentes (2,3) se situe dans la gamme de 5:1 à 50:1.

12. Élément magnétorésistif selon l'une quelconque des revendications 1 à 11, dans lequel le rapport desdites forces coercitives dans les couches minces ferromagnétiques adjacentes (2,3) se situe dans la gamme de 8:1 à 20:1.

13. Élément magnétorésistif selon l'une quelconque des revendications 1 à 12, dans lequel ladite couche non magnétique (4) est faite d'un matériau non magnétique sélectionné dans le groupe constitué de Au, Ag, Cu, Pt, Al, Mg, Mo, Zn, Nb, Ta, V, Hf, Sb, Zr, Ga, Ti, Sn et Pb, et des composés de ceux-ci, et de $SiO_2$, SiO, SiN, $Al_2O_3$, ZnO, MgO, et TiN, et ces composés auxquels un autre élément est ajouté.

14. Élément magnétorésistif selon l'une quelconque des revendications 1 à 13, dans lequel ladite couche non magnétique (4) a une épaisseur de $4 \cdot 10^{-4}$ µm à $2 \cdot 10^{-2}$ µm (4 à 200 angströms).

15. Élément magnétorésistif selon l'une quelconque des revendications 1 à 14, dans lequel ladite couche sous-jacente est une couche de Cr d'environ $5 \cdot 10^{-3}$ µm (50 angströms) d'épaisseur et lesdits deux types de couches minces ferromagnétiques comprennent une couche de Co d'environ $10^{-3}$ µm (10 angströms) d'épaisseur et une couche de Ni-Fe d'environ $10^{-3}$ µm (10 angströms) d'épaisseur, lesdites couches de Co et de Ni-Fe étant successivement empilées en alternance environ 5 fois sur ladite couche de Cr avec interposition d'une couche de Cu d'environ $4 \cdot 10^{-3}$ µm (40 angströms) d'épaisseur.

16. Procédé de fabrication d'un élément magnétorésistif dans lequel une couche sous-jacente est formée sur un substrat de verre (1) et une pluralité de couches minces ferromagnétiques (2,3) ayant chacune des forces coercitives différentes sont empilées sur la couche sous-jacente, une couche non magnétique (4) étant interposée entre chacune des couches ferromagnétiques adjacentes (2,3) ; consistant à mettre sous forme de film de chacune desdites couches minces ferromagnétiques dans un champ magnétique de façon à ce que l'axe de facile aimantation dans chacune desdites couches minces ferromagnétiques (2,3) soit parallèle à une direction d'un champ magnétique de signal devant être appliqué, dans lequel la couche sous-jacente est faite d'un matériau sélectionné dans le groupe constitué de Au, Cu, Ag, Pt, Cr et Fe.

# FIG.1

# FIG.2A

EASY AXIS

SENSE CURRENT $M_2$

$\theta$ $M_3$

6

SIGNAL MAGNETIC FIELD

# FIG.2B

EASY AXIS

SENSE CURRENT $M_2$ $M_3$

6

$\theta$

SIGNAL MAGNETIC FIELD